# EUROPEAN PATENT APPLICATION

(11) **EP 2 854 183 A1**
(43) Date of publication of application: **01.04.2015**
(21) Application number: 14151032.1
(22) Date of filing: 14.01.2014
(51) Int. Cl.: H01L 31/0224, H01L 31/061

(54) **Back contact solar cell**

(30) Priority: 25.09.2013 TW 102217943
(71) Applicant: Inventec Solar Energy Corporation, Taoyuan County 33547 (TW)
(72) Inventor: Chien, Jung-Wu, 33547 Daxi Township, Taoyuan County (TW); Lin, Chia-Lung, 33547 Daxi Township, Taoyuan County (TW); Chen, Chuan Chi, 33547 Daxi Township, Taoyuan County (TW)
(74) Representative: Petraz, Gilberto Luigi

(57) **Abstract**

A back contact solar cell is disclosed herein. The back contact solar cell includes a base diffusion region, a plurality of emitter diffusion regions, a plurality of base contact points, and a plurality of emitter contact points. Each of the emitter diffusion regions is implemented as a brick pattern structure and surrounded by the base diffusion region. The base contact points are disposed in the base diffusion region, and the base contact points are disposed between the emitter diffusion regions. Each of the emitter contact points is disposed at center of each emitter diffusion regions.

## Description

### FIELD OF THE DISCLOSURE

The present invention relates to a solar cell, and more particularly relates to a back contact solar cell, which can shorten a path for collecting carriers.

### BACKGROUND OF THE DISCLOSURE

Since the conversion efficiency of the back contact solar cell is proved to be over 20%, most of the manufacturing vendors are eager to develop the back contact solar cell. The electrode members, which are used to be disposed on the top side, are disposed on the back side now, thus the area where the electrode members shading on the top side is reduced and the photovoltaic conversion efficiency of the back contact solar cell is enhanced.

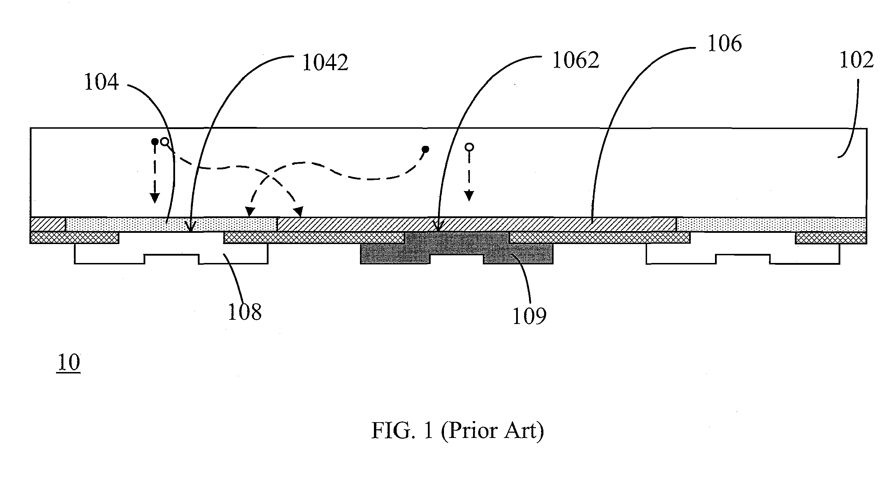

FIG. 1 is a sectional view of a conventional back contact solar cell. As shown in FIG. 1, the conventional back contact solar cell 10 includes a silicon wafer 102, a base diffusion region 104, and an emitter diffusion region 106. There are a plurality of base contacts 1042 and emitter contacts 1062 respectively disposed on the base diffusion region 104 and the emitter diffusion region 106. The base electrode member 108 is electrically connected with the base diffusion region 104 from the base contacts 1042. Therefore, the majority charge carriers (electrons) collected in the base diffusion region 104 can be transmitted to an external circuit from the base electrode members 108. Similarly, the emitter electrode member 109 is electrically connected with the emitter diffusion region 106 from the emitter contacts 1062. Therefore, the minority charge carriers (electron holes) collected in the emitter diffusion region 106 can be transmitted to the external circuit from the emitter electrode members 109.

However, in the back contact solar cell 10, the carriers are mostly generated on the top side of the solar cell, and the majority carriers or the minority carriers are requested to travel from the generation points to the back side. The path which the carriers travel is called a carrier path. The traveling path for collecting the carriers can be shortened to reduce the recombination loss of the minority charge carriers, or the serial resistance loss caused by the horizontal flowing of the majority charge carriers, so as to enhance the conversion efficiency of the solar cell. Accordingly, the traveling path for collecting the carriers is a significant factor in determining the capability of the back contact solar cell 10.

Therefore, a need has arisen to design a structure of the back contact solar cell to shorten the traveling path for collecting the carriers and enhance the capability of the back contact electrode solar cell.

### SUMMARY OF THE DISCLOSURE

One objective of the present invention is to provide a structure of a back contact solar cell to shorten the traveling path to collect carriers so as to enhance the capability of the solar cell.

According to the objective described above, a back contact solar cell is disclosed herein and includes a base diffusion region, a plurality of emitter diffusion regions, and a plurality of base electrodes. The base diffusion region forms a plurality of openings thereon, and each of the emitter diffusion regions is a brick pattern structure disposed within the openings of the base diffusion region and surrounded by the base diffusion region. The base contacts are disposed on the base diffusion region and located between the emitter diffusion regions. Each of the emitter contacts is disposed at central position in each of the emitter diffusion regions.

Another objective of the present invention is to provide a structure of a back contact solar cell to speed up the transmission of the majority charge carrier or the minority charge carrier so as to reduce the recombination loss of the minority charge carriers, or the serial resistance loss caused by the horizontal flowing of the majority charge carriers, and enhance the conversion efficiency of the solar cell.

According the objective above, a back contact solar cell is disclosed herein and includes a silicon wafer, a base diffusion region, a plurality of emitter diffusion regions, an insulated layer, a plurality of base contacts, and a plurality of emitter contacts. The base diffusion region is disposed on the back side of the silicon wafer, and forms a plurality of openings thereon. The emitter diffusion regions are disposed on the back side of the silicon wafer and respectively disposed within the openings. Each of the emitter diffusion regions is a brick pattern structure and surrounded by the base diffusion region. The insulated layer is disposed on top of the base diffusion region and the emitter diffusion regions. The base contacts are disposed on the base diffusion region and located between the emitter diffusion regions. Each of the emitter contacts is disposed at a central position in each of the emitter diffusion regions.

### DESCRIPTION OF THE DRAWINGS

FIG. 1 is a sectional view of a conventional back contact solar cell;
FIG. 2A is a view of a back contact solar cell illustrated in one embodiment of the present invention;
FIG. 2B is a view of the electrode layout of the back contact solar cell in the embodiment of the present invention;
FIG. 2C, FIG. 2D and FIG. 2E are views of the emitter diffusion region in the embodiment of the present invention; and
FIG. 3 is a three-dimensional sectional view of the back contact solar cell in the embodiment of the present invention.

### DETAILED DESCRIPTION OF THE PREFERRED EMBODIMENTS

The above-mentioned description of the present invention can be best understood by referring to the following detailed description of the preferred embodiments and the accompanying drawings.

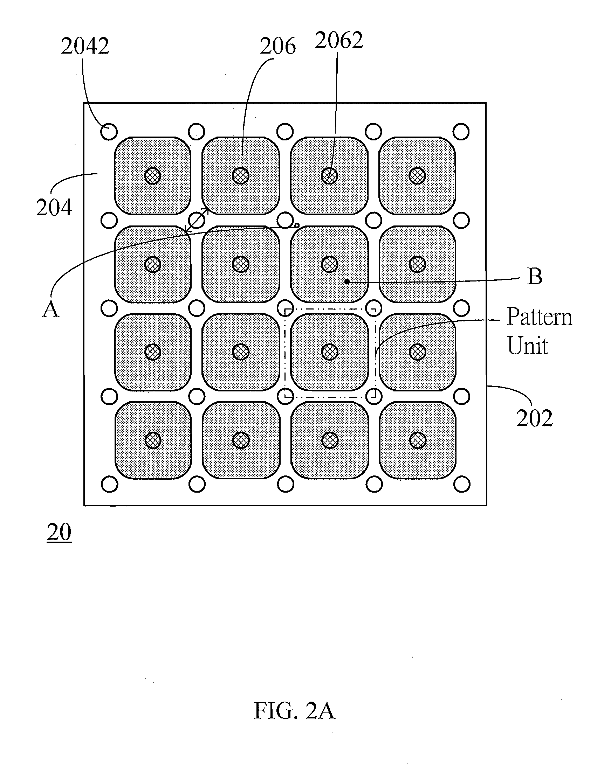

FIG. 2A is a view of a back contact solar cell illustrated in one embodiment of the present invention. As shown in FIG. 2A, the back contact solar cell 20 includes a solar wafer 202, a base diffusion region 204, and a plurality of emitter diffusion regions 206. The base diffusion region 204 and the emitter diffusion regions 206 are disposed on the back side of the solar wafer 202. Each of the emitter diffusion regions 206 is a brick pattern structure, and the base diffusion region 204 surrounds the brick pattern structure of the emitter diffusion region 206. In the present embodiment, the emitter diffusion regions 206 are arranged as multiple columns, and every two columns of the adjacent emitter diffusion regions 206 are aligned to each other. In addition, there are plural of base contacts 2042 and plural of emitter contacts 2062 respectively included on the base diffusion region 204 and the emitter diffusion region 206. The base contacts 2042 are disposed on the base diffusion region 204, and the disposing position of each of the base contacts 2042 is preferred to be in a corner close to each of the emitter diffusion regions 206 to have a larger alignment space during the manufacturing process. However, in a different embodiment, under the control capability of the manufacturing process, the disposing position for each of the base contacts 2042 can be in any locations on the base diffusion region 204, and it is not limited herein. In addition, for optimizing the contact resistance, the base contact 2042 is not limited to being designed as a circular or rectangular shape. Each of the emitter contacts 2062 is disposed within the brick pattern structure of each of the emitter diffusion regions 206, and is preferably at the center of the brick pattern. The intervals between every two of the emitter contacts 2062 are the same. However, in a different embodiment, in order to optimize the contact resistance, the emitter contacts 2062 can be a plurality of circular shaped contacts, rectangular shaped contacts, or any other shape contacts. As the example shown in FIG. 2A, in one embodiment of the present invention, for one 400um X 400um unit of the silicon wafer, each of the emitter diffusion regions 206 is a square-like brick pattern structure about 350um wide. The four corners of the square pattern are shrunk a little to reserve a larger space of the base diffusion region to arrange the base contacts 2042, and the width of the base diffusion region at the location of the corner is a small square shape about 140um wide. The minimum width of the base diffusion region 204 between the two emitter diffusion regions is about 50 um wide and the width of the base contacts 2052 and the width of the emitter contacts 2062 are 60um and 80um respectively. In addition, it should be noted that the base diffusion regions 204, the emitter diffusion regions 206, the base contacts 2042, and the emitter contacts 2062 can be made by the semiconductor process, such as deposing, coating, masking, laser, etching, and so on, and those semiconductor processes are well known to a person with ordinary skill in the art and the description thereof is omitted herein.

Still referring FIG. 2A, as shown in FIG. 2A, a carrier A and a carrier B are disposed on the back contact electrode member. The carrier A is a minority charge carrier and the carrier A can reach the emitter diffusion region 206 from an up, down, right or left direction. Therefore, the carrier A can have the shortest path to reach the emitter diffusion region 206. The carrier B is a majority charge carrier and the carrier B can also reach the base diffusion region 205 from the up, down, right or left direction. Therefore, the carrier B can have the shortest path to reach the base diffusion region 204. By the structure of the back contact solar cell in the present invention, regardless of the direction, the majority charge carriers or the minority charge carriers can find the shortest path to reach the base diffusion region 204 or the emitter diffusion region 206. According to the conventional back contact electrode solar cell, the best path can only be found from the right or left direction or the up or down direction. The transmitting efficiency of the carriers in the back contact solar cell of the present invention is much better.

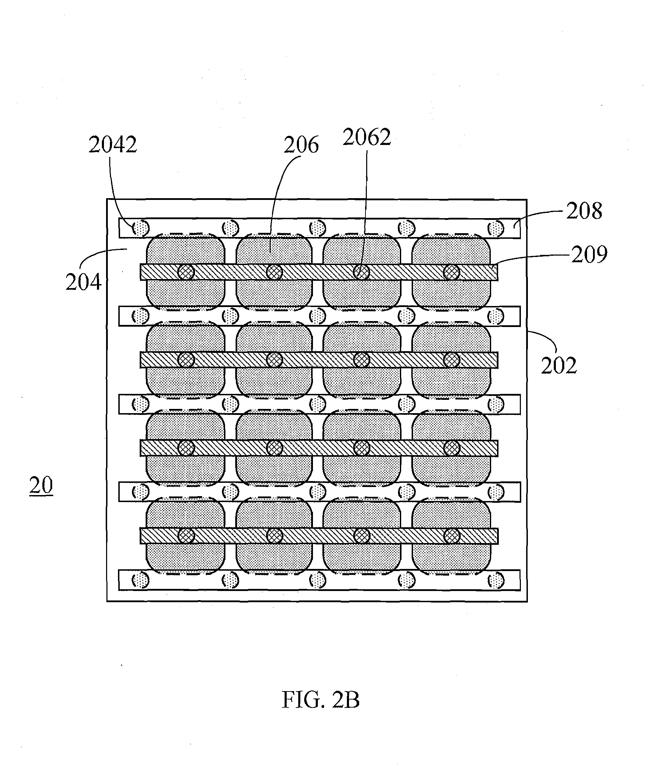

FIG. 2B is a view of the electrode layout of the back contact solar cell in the embodiment of the present invention. As shown in FIG. 2B, after the installation of the base diffusion region 204, the emitter diffusion region 206, the base contacts 2042 and the emitter contacts 2062, in order for the collected majority carrier able to be transmitted to the external circuit from the base diffusion region 205, there are multiple base electrode members 208 disposed on the base contacts 2042. The base electrode members 208 are long strip shapes, and are electrically connected with the base diffusion region 204 by each of the base contacts 2042. Subsequently, the base electrode member 208 is electrically connected with the external circuit, and the majority charge carriers (electrons) collected in the base diffusion region 204 can be transmitted to the external circuit. Similarly, there are multiple emitter electrode members 209 disposed on the emitter contacts 2062. The emitter electrode members 209 are also long strip shapes, and are electrically connected with the emitter diffusion region 206 by the emitter contacts 2062. Therefore, the minority charge carrier 209 (electron holes) collected in the emitter diffusion region 206 can be transmitted to the external circuit. Alternatively, in a different embodiment, there are some conductive metal materials filled within the base contacts 2042 and the emitter contacts 2062 first, and then the base electrode members 208 and the emitter electrode members 209 are disposed on the base contacts 2042 and the emitter contacts 2062. Alternatively, the base electrode members 208 and the emitter electrode member 209 are pin-like structures, and the base electrode members 208 and the emitter electrode members 209 are directly and electrically connected with the base diffusion region 204 and the emitter diffusion region 206 from the base contacts 2042 and the emitter contacts 2062 by those pins, and it is not limited herein. Moreover, the base electrode members 208 and the emitter electrode members 209 are paralleled to each other, and there is an insulated layer disposed between the base electrode members 208 and the emitter diffusion region 206, or the base electrode members 208 and the emitter electrode members 209, to prevent the base electrode members 208 and the emitter electrode members 209 from being electrically contacted.

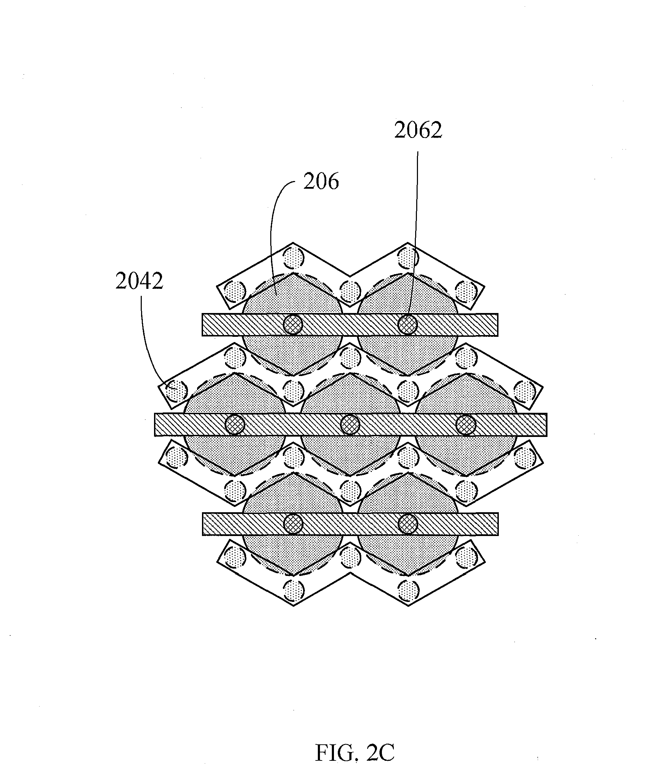

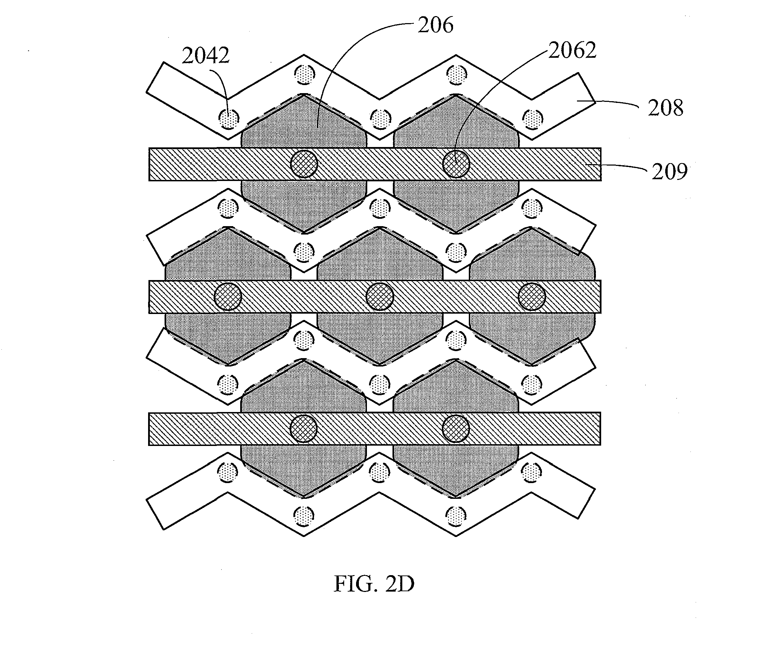

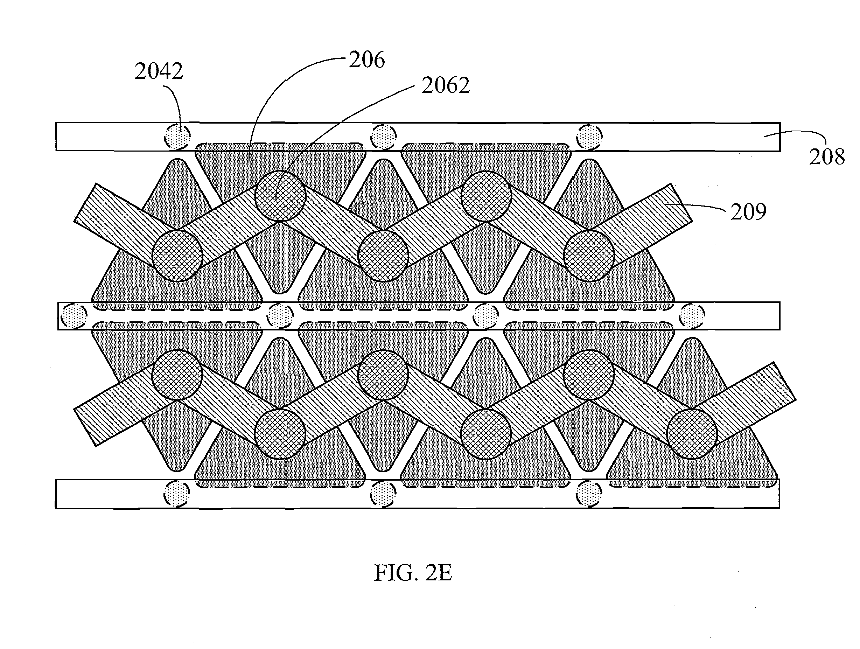

In addition, in a different embodiment, the arrangement pattern or shape of the emitter diffusion region 206 can be different from the emitter diffusion region 206 shown in FIG. 2A. For example, in the embodiment of FIG. 2C, all of the emitter diffusion regions 206 are circularly shaped, and every two columns of the adjacent emitter diffusion regions 206 can be misaligned to each other. The base electrode member 208 can be arranged in a sawtooth-like shape. And, in the embodiment shown in FIG. 2D, the emitter diffusion regions 206 are hexagon shaped, and the base electrode members 208 are arranged between the two emitter diffusion regions 206. The base electrode members 208 are also arranged in a sawtooth-like shape. In the embodiment shown in FIG. 2E, the emitter diffusion regions 206 are triangular shapes, and the base electrode members 208 are long strip shapes, and the emitter electrode members 209 are arranged in a sawtooth-like shape. As the embodiments mentioned above, the base electrode regions 206 of the present invention can be shown in different shapes in accordance with the different embodiments. The base electrode members 208 are not always arranged as long strip shapes to let the majority charge carriers or the minority charge carriers find the best path to reach the base diffusion region 204 or the emitter diffusion region 206.

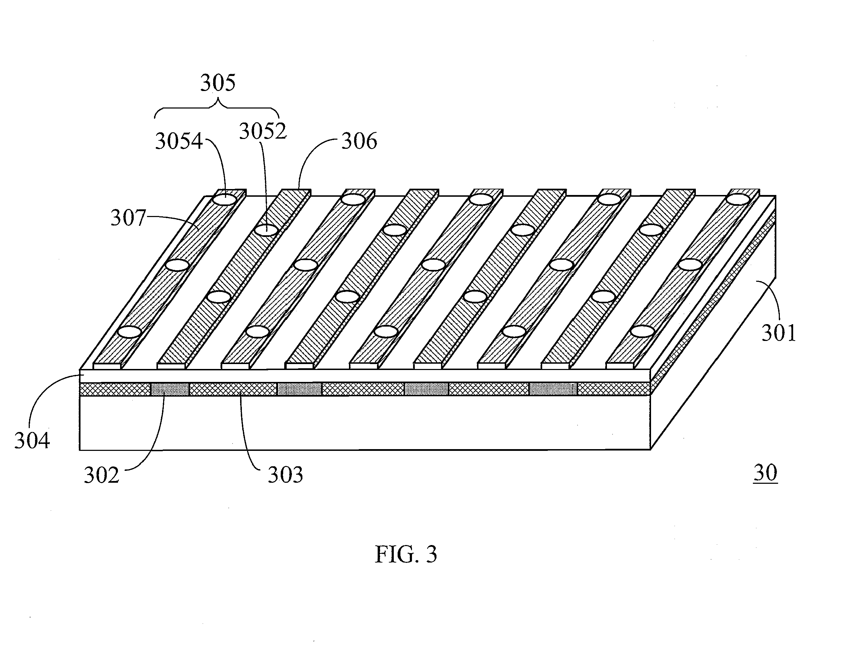

FIG. 3 is a three-dimensional sectional view of the back contact solar cell in the embodiment of the present invention. As shown in FIG. 3, the back side of the solar cell 30 in FIG. 3 is on the top. The bottom layer is a silicon wafer 301, and the top of the silicon wafer 301 is a base diffusion region 302. There are a plurality of openings (not shown) formed on the base diffusion region 302. Thereafter, emitter diffusion regions 303 are disposed on the openings, and an insulated layer 304 is disposed on the base diffusion region 302 and the emitter diffusion regions 303. There are multiple through holes dug on the insulated layer 304 to form multiple contacts 305. The contacts 305 on the insulated layer 304 to expose the base diffusion region 302 are base contacts 3052, and the contacts 305 on the insulated layer 304 to expose the emitter diffusion regions 303 are emitter contacts 3054. Thereafter, multiple base electrode members 306 with long strip shapes are disposed on the base contacts 3052, and the multiple emitter electrode members 307 with long strip shapes are disposed on the emitter contacts 3054. It is obvious to see in figures that the base electrode members 306 and the emitter electrode members 307 are not electrically connected with the emitter diffusion region 303 and the base diffusion region 302 at the bottom because of the insulated layer 304. According to the design of the solar cell mentioned above, the majority charge carriers or the minority charge carriers can find the shortest path to reach the base diffusion region 302 or the emitter diffusion region 303 so as to speed up the transmission of the majority charge carriers or the minority charge carriers and reduce the recombination loss of the minority charge carriers or the serial resistance loss caused by the horizontal flowing of the majority charge carriers to enhance the conversion efficiency of the solar cell.

As stated above, the present invention has been described with preferred embodiments thereof and it is understood that many changes and modifications to the described embodiments can be carried out without departing from the scope and the spirit of the disclosure that is intended to be limited only by the appended claims.

## Claims

1. A back contact solar cell (20), **characterized in that** the back contact solar cell comprises:
a base diffusion region (204) having a plurality of openings formed thereon;
a plurality of emitter diffusion regions (206) and each of the emitter diffusion regions (206) being a brick pattern structure disposed within one of the openings of the base diffusion region (204) and surrounded by the base diffusion region (204);
a plurality of base contacts (2042) disposed on the base diffusion region (204) and located between the emitter diffusion regions (206); and
a plurality of emitter contacts (2062) and each of the emitter contacts (2062) being disposed at central position in each of the emitter diffusion regions (206).

2. The back contact solar cell according to claim 1, **characterized in that** the base diffusion region (204), the emitter diffusion region (206), the base contacts (2042), and the emitter contacts (2062) are disposed on the back side of the back contact solar cell (20).

3. The back contact solar cell according to claim 1, **characterized in that** the back contact solar cell (20) further comprises a plurality of base electrode members (208) and a plurality of emitter electrode members (209), and each of the base electrode members (208) is electrically contacted with the base diffusion region (204) from the base contacts (2042), and each of the emitter electrode members (209) is electrically contacted with the emitter diffusion region (206) from the emitter contacts (2062).

4. The back contact solar cell according to claim 3, **characterized in that** the base electrode members (208) are electrically isolated from the emitter electrode members (209).

5. The back contact solar cell according to claim 1, **characterized in that** the base diffusion region (204) is configured for collecting majority charge carriers and the emitter diffusion region (206) is configured for collecting minority charge carriers.

6. The back contact solar cell according to claim 1, **characterized in that** intervals between every two of the adjacent base contacts (2042) are the same, and the intervals between every two of the adjacent emitter contacts (2062) are the same.

7. The back contact solar cell according to claim 1, **characterized in that** each of the base contacts (2042) is located at a corner close to the outside of the emitter diffusion regions (206).

8. The back contact solar cell according to claim 1, **characterized in that** the emitter diffusion regions (206) are arranged as a plurality of columns and every two adjacent columns of the emitter diffusion regions (206) are misaligned to each other.

9. The back contact solar cell according to claim 1, wherein the emitter diffusion regions (206) are arranged as a plurality of columns, and every two columns of the adjacent emitter diffusion regions (206) are aligned to each other.

10. A back contact solar cell, **characterized in that** the back contact solar cell comprises:
a silicon wafer (202);
a base diffusion region (204) disposed on back side of the silicon wafer (202), and having a plurality of openings formed thereon;
a plurality of emitter diffusion regions (206) disposed on the back side of the silicon wafer and respectively disposed within the openings, each of the emitter diffusion regions (206) being a brick pattern structure and surrounded by the base diffusion region (204);
an insulated layer (304) disposed on the base diffusion region (204) and the emitter diffusion region (206);
a plurality of base contacts (2042) disposed on the base diffusion region (204) and located between the emitter diffusion regions (206); and
a plurality of emitter contacts (2062) and each of the emitter contacts being disposed at central position in each of the emitter diffusion regions (206).

11. The back contact solar cell according to claim 10, **characterized in that** the back contact solar cell (20) further comprises a plurality of base electrode members (208) and a plurality of emitter electrode members (209), and each of the base electrode members (208) is electrically contacted with the base diffusion region (204) from the base contacts (2042) and each of the emitter electrode members (209) is electrically contacted with the emitter diffusion region (2062) from the emitter contacts (209).

12. The back contact solar cell according to claim 11, **characterized in that** the base electrode members (2042) are electrically isolated from the emitter electrode members (2062).

13. The back contact solar cell according to claim 10, **characterized in that** the base diffusion region (204) is configured for collecting majority charge carriers and the emitter diffusion region (206) is configured for collecting minority charge carriers.

14. The back contact solar cell according to claim 10, **characterized in that** intervals between every two of the adjacent base contacts (2042) are the same and the intervals between every two of the adjacent emitter contacts (2062) are the same.

15. The back contact solar cell according to claim 10, **characterized in that** each of the base contacts (2042) is located at a corner close to the outside of the emitter diffusion regions (206).

16. The back contact solar cell according to claim 10, **characterized in that** the emitter diffusion regions (206) are arranged as a plurality of columns, and two adjacent columns of the emitter diffusion regions (206) are misaligned to each other.

17. The back contact solar cell according to claim 10, **characterized in that** the emitter diffusion regions (206) are arranged as a plurality of columns and two adjacent columns of the emitter diffusion regions (206) are aligned to each other.

## Amended claims

### Amended claims in accordance with Rule 137(2) EPC.

1. A back contact solar cell (20), **characterized in that** the back contact solar cell comprises:
a base diffusion region (204) having a plurality of openings formed thereon;
a plurality of emitter diffusion regions (206) and each of the emitter diffusion regions (206) being a brick pattern structure disposed within one of the openings of the base diffusion region (204) and surrounded by the base diffusion region (204);
a plurality of base contacts (2042) disposed on the base diffusion region (204) and located between the emitter diffusion regions (206); and
a plurality of emitter contacts (2062) and each of the emitter contacts (2062) being disposed at central position in each of the emitter diffusion regions (206), wherein the emitter diffusion regions (206) are arranged as a plurality of columns and every two adjacent columns of the emitter diffusion regions (206) are misaligned to each other.

2. The back contact solar cell according to claim 1, **characterized in that** the base diffusion region (204), the emitter diffusion region (206), the base contacts (2042), and the emitter contacts (2062) are disposed on the back side of the back contact solar cell (20).

3. The back contact solar cell according to claim 1, **characterized in that** the back contact solar cell (20) further comprises a plurality of base electrode members (208) and a plurality of emitter electrode members (209), and each of the base electrode members (208) is electrically contacted with the base diffusion region (204) from the base contacts (2042), and each of the emitter electrode members (209) is electrically contacted with the emitter diffusion region (206) from the emitter contacts (2062).

4. The back contact solar cell according to claim 3, **characterized in that** the base electrode members (208) are electrically isolated from the emitter electrode members (209).

5. The back contact solar cell according to claim 1, **characterized in that** the base diffusion region (204) is configured for collecting majority charge carriers and the emitter diffusion region (206) is configured for collecting minority charge carriers.

6. The back contact solar cell according to claim 1, **characterized in that** intervals between every two of the adjacent base contacts (2042) are the same, and the intervals between every two of the adjacent emitter contacts (2062) are the same.

7. The back contact solar cell according to claim 1, **characterized in that** each of the base contacts (2042) is located at a corner close to the outside of the emitter diffusion regions (206).

8. The back contact solar cell according to claim 1, **characterized in that** the back contact solar cell further comprises a silicon wafer (202), the base diffusion region (204) disposed on back side of the silicon wafer (202), and the plurality of emitter diffusion regions (206) disposed on the back side of the silicon wafer (202).
